# EUROPEAN PATENT SPECIFICATION

(11) **EP 2 093 307 B1**
(45) Date of publication and mention of the grant of the patent: **27.02.2013**
(21) Application number: 09250246.7
(22) Date of filing: 29.01.2009
(51) Int. Cl.: C23C 14/32, F01D 5/28, C23C 28/02

(54) **Cathodic arc deposition coatings for turbine engine components**
Kathodenbogenbeschichtungen für Turbinenmotorbestandteile
Revêtements de dépôts par arc cathodique pour composants de moteur à turbine

(30) Priority: 30.01.2008 US 11872
(43) Date of publication of application: 26.08.2009
(73) Proprietor: United Technologies Corporation, Hartford, CT 06101 (US)
(72) Inventor: Tryon, Brian S., Glastonbury, CT 06033 (US); Dileo, Michael, Columbia, CT 06237 (US); Beers, Russell A., Manchester, CT 06040 (US)
(74) Representative: Tomlinson, Kerry John

(56) References cited:
- EP-A- 0 814 178
- EP-A- 0 897 996
- EP-A- 1 111 086

## Description

### BACKGROUND

The present invention relates to protective coatings for turbine engine components, such as aerospace components. In particular, the present invention relates to coatings that provide oxidation and corrosion resistance to turbine engine components and methods for forming the coatings.

A gas turbine engine typically consists of an inlet, a compressor, a combustor, a turbine, and an exhaust duct. The compressor draws in ambient air and increases its temperature and pressure. Fuel is added to the compressed air in the combustor, where it is burned to raise gas temperature, thereby imparting energy to the gas stream. To increase gas turbine engine efficiency, it is desirable to increase the temperature of the gas entering the turbine stages. This requires the first stage turbine engine components (e.g., vanes and blades) to be able to withstand the thermal and oxidation conditions of the high temperature combustion gas during the course of operation.

To protect turbine engine components from the extreme conditions, such components typically include metallic coatings (e.g., aluminides and MCrAlY coatings) that provide oxidation and/or corrosion resistance. The metallic coatings may also function as bond coats to adhere thermal barrier coatings to the substrates of the turbine engine components. Existing bond coats are applied to turbine engine components using a variety of deposition techniques (e.g., plasma spraying, pack cementation, and chemical vapor deposition techniques). The ceramic thermal barrier coatings are then applied over the bond coats to thermally insulate the turbine engine component from the extreme operating conditions.

Current MCrAlY overlay coatings offer superior oxidation resistance to single-crystal nickel-base superalloys compared to platinum-modified aluminide diffusion coatings. However, MCrAlY overlay coatings may exhibit an oxidation debit compared to different metallic coatings on polycrystalline/equiaxed and directionally solidified nickel-base alloys. Thus, there is an ongoing need for protective coatings that provide good oxidation resistance to single-crystal nickel-base superalloys and to polycrystalline/equiaxed/directionally-solidified nickel-base alloys.

EP1111086 A1 discloses a cathode made of MCrAlY alloy for cathodic arc deposition where the cathode has a coating having a composition different from that of the bulk cathode. The coating may include elements such as Re to provide a diffusion barrier to reduce interdiffusion between a substrate and outer coatings.

### SUMMARY

The present invention relates to a method for coating a metal component of a gas turbine engine, and a coated metal component formed with the method. The method includes forming a cathode ingot for a cathodic arc deposition process, where the cathode ingot includes an MCrAIY alloy base portion and a platinum-modified aluminide outer coating disposed over the base portion. The method further includes performing a cathodic arc deposition process on the metal component with the cathode ingot to form a bond coat. The resulting bond coat includes a platinum-modified aluminide buffer coating disposed on a surface of the metal component, and an MCrAlY alloy overlay coating disposed over the buffer coating.

### BRIEF DESCRIPTION OF THE DRAWINGS

FIG. 1 is a flow diagram of a method for coating a metal component of a gas turbine engine with a cathodic arc deposition process.

FIGS. 2A-2C are sectional views of a cathode ingot being formed, where the cathode ingot is subsequently used in the cathodic arc deposition process.

FIG. 3A-3C are sectional views of a metal component being coated with the cathodic arc deposition process.

### DETAILED DESCRIPTION

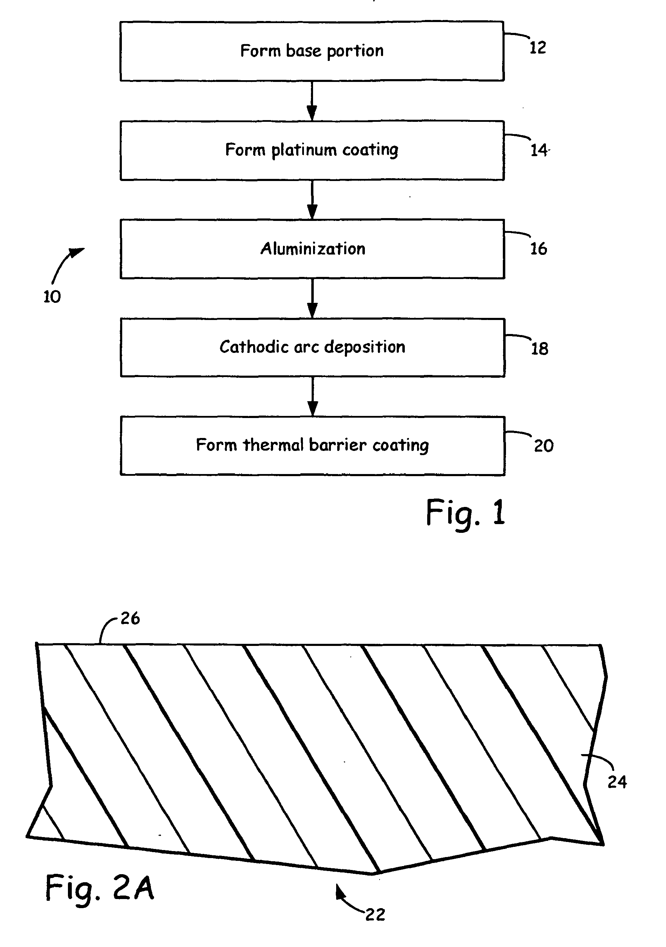

FIG. 1 is a flow diagram of method 10 for forming a protective bond coat on a metal component of a gas turbine engine, such as a turbine-stage component (e.g., turbine blades and vanes). As shown, method 10 includes steps 12-20, and generally involves forming a cathode ingot (steps 12, 14, and 16) and using the cathode ingot in a cathodic arc deposition process to form the bond coat on the metal component (step 18). The formation of the cathode ingot initially involves forming a base portion of the cathode ingot from an M-chromium-aluminum-yttrium (MCrAlY) alloy, which provides oxidation and/or corrosion resistance (step 12). As used herein, the term "M" in the MCrAlY alloy may be nickel, cobalt, iron, or a combination thereof (e.g., NiCrAlY, CoCrAlY, FeCrAlY and NiCoCrAlY alloys). As discussed below, the cathode ingot functions as a source of the coating materials used to form the protective bond coat on the metal component with the cathodic arc deposition process. This allows the bond coat to provide oxidation and/or corrosion resistance to the metal component during the course of operation in a gas turbine engine.

After the base portion of the cathode ingot is formed, platinum is deposited on one or more surfaces of the base portion to form a platinum coating on the base portion (step 14). An aluminization process is then performed on the platinum-coated base portion to form a platinum-modified aluminide (PtAl) coating that is interdiffused with the MCrAlY alloy at the surfaces of the base portion (step 16). As a result, the cathode ingot has a PtAl coating at the surface, a base portion derived of the MCrAlY alloy, and a compositional gradient between the PtAl coating and the base portion that gradually transitions from the platinum-modified aluminide to the MCrAlY alloy. After formation, the cathode ingot may then be mounted in a chamber of a cathodic arc deposition system along with the metal component to be coated. As discussed below, multiple metal components may be simultaneously coated in the cathodic arc deposition system using the cathode ingot.

A cathodic arc deposition process is then performed on the metal component using the cathode ingot (step 18). As discussed below, this forms a bond coat on the metal component that has a compositional profile that inversely corresponds to the compositional profile of the cathode ingot. Thus, after the cathodic arc deposition process is complete, the resulting bond coat includes an initial layer of platinum-modified aluminide disposed on the surfaces of the metal component, a compositional gradient that transitions from the platinum-modified aluminide to the MCrAIY alloy, and a bulk exterior layer derived of the MCrAlY alloy. This combination provides good oxidation and/or corrosion protection to the metal component regardless of the microstructure of the metal component (e.g., single-crystal and polycrystalline/equiaxed/directionally-solidified microstructures). Additionally, because platinum is a slow diffusing element, the high concentration of platinum at the surfaces of the metal component reduces the formation of deleterious phases (e.g., secondary reaction zones) near the surfaces of the metal component.

After the bond coat is formed on the metal component, a thermal barrier coating may then be formed on the bond coat to thermally insulate the metal component during the course of operation in a gas turbine engine (step 20). The MCrAIY of the bond coat accordingly provides good adhesion between the metal component and the thermal barrier coating. In an alternative embodiment, step 20 may be omitted, and the bond coat may function as the sole protective coating for the metal component.

FIGS. 2A-2C are sectional views of cathode ingot 22, which illustrate the formation of cathode ingot 22 pursuant to steps 12-16 of method 10 (shown in FIG. 1). As shown in FIG. 2A, cathode ingot 22 includes base portion 24, which, as discussed above, is formed from an MCrAlY alloy. Examples of suitable compositions for the MCrAlY alloy include chromium concentrations ranging from about 4% by weight to about 25% by weight, aluminum concentrations ranging from about 5% by weight to about 20% by weight, yttrium concentrations ranging from about 0.1% by weight to about 2.0% by weight, and the balance being nickel, iron, and/or cobalt. The MCrAlY may also include one or more additional materials such as hafnium, silicon, tantalum, tungsten, rhenium, zirconium, niobium, titanium, and molybdenum.

Pursuant to step 12 of method 10, base portion 24 may be formed in a variety of manners such that base portion 24 contains dimensions suitable for use in a cathodic arc deposition system (e.g., puck-shape geometries). Examples of suitable techniques for forming base portion 24 include metal powder pressing, hot-isostatic pressing, and casting techniques. In one embodiment, base portion 24 is formed by a casting process that involves vacuum induction melting (VIM). In this process, the MCrAIY alloy is heated above the melting temperature of the alloy in a partial pressure of an inert gas, or alternatively, under a vacuum. While molten, the MCrAlY alloy is then cast to the desired dimensions, and the resulting cast part is then hot-isostatic pressed at an elevated temperature (e.g., about 1,200°C/2,200°F). The resulting base portion 24, which includes surface 26, may then be cooled to room temperature for subsequent processing.

The exterior surfaces of base portion 24 (e.g:, surface 26) may then be cleaned to remove any residual impurities and debris. For example, surface 26 may be grit blasted to smooth surface 26, and rinsed clean with a solvent (e.g., acetone). Suitable grit blasting conditions include a 240 grit size blasting media, a pressure of about 275 kilopascals (about 40 psi), and a duration ranging from about three to about five minutes. Surface 26 may also be electrically cleaned using an alkali solution. Suitable process conditions for the electrical cleaning include a duration of about 3 minutes, with a temperature of about 50°C (about 125°F), and a current of about 0.25 amperes.

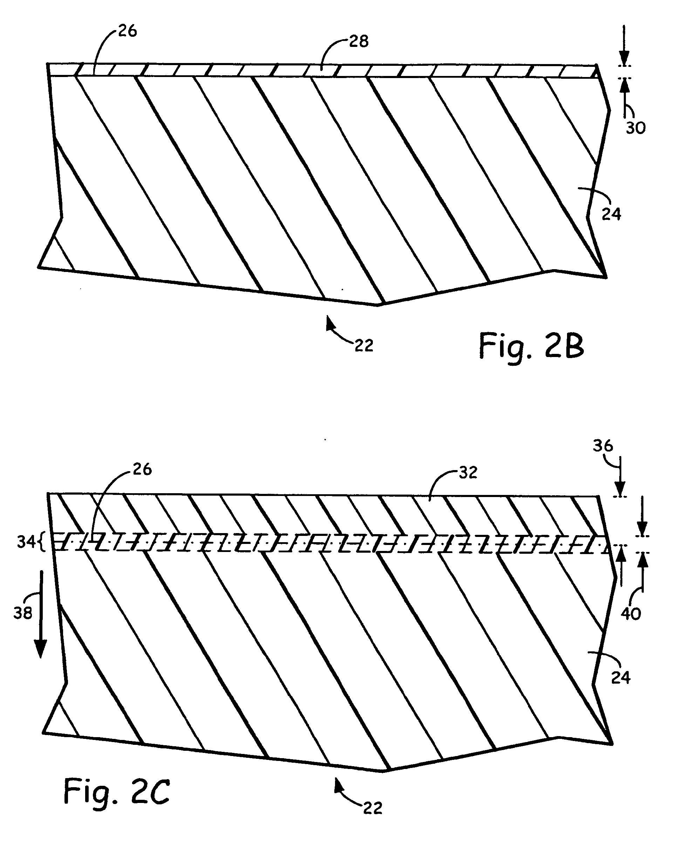

As shown in FIG. 2B, pursuant to step 14 of method 10, platinum coating 28 is formed on surface 26 of base portion 24. Platinum coating 28 may be formed on surface 26 using a variety of techniques, such as electroplating processes and physical vapor deposition techniques. In one embodiment, platinum coating 28 is desirably formed by an electroplating process, where base portion 24 is immersed in a bath that contains a plating solution (not shown). Suitable plating solutions include solutions of platinum-salts in carrier fluids. As used herein, the term "solution" refers to any suspension of particles in a carrier fluid (e.g., water), such as dissolutions, dispersions, emulsions, and combinations thereof. Suitable concentrations of platinum-salts in the plating solution range from about 15 grams/liter to about 50 grams/liter, with particularly suitable concentrations ranging from about 25 grams/liter to about 35 grams/liter.

After base portion 24 is immersed in the bath, a negative charge is placed on base portion 24 and a positive charge is placed on the plating solution. The positive charge causes the platinum-salts of the plating solution to disassociate, thereby forming positive-charged platinum ions in the carrier fluid. The negative charge placed on base portion 24 attracts the platinum ions toward the surfaces of base portion 24 (e.g., surface 26), and reduces the positive charges on the platinum ions upon contact with base portion 24. This forms platinum coating 28 bonded to the surfaces of the base portion 24, including surface 26.

The electroplating process is performed for a duration, and with a plating current magnitude, sufficient to build platinum coating 28 to a desired thickness on base portion 24. The average thickness of platinum coating 28 is represented as coating thickness 30 in FIG. 2B, and is measured from surface 26 of base portion 24. As discussed below, coating thickness 30 affects the amount of platinum-modified aluminide that forms on the surfaces of the metal component (not shown in FIG. 2B) during the subsequent cathodic arc deposition process. Examples of suitable coating thicknesses 30 for platinum coating 28 after step 14 of method 10 include thicknesses ranging from about 1 micrometer to about 20 micrometers, with particularly suitable thicknesses ranging from about 5 micrometers to about 10 micrometers. Examples of suitable processing conditions for the electroplating process include a duration ranging from about one hour to about two hours, a temperature of ranging from about 87°C (about 190°F) to about 93°C (about 200°F), and a plating current ranging from about 0.2 amperes to about 0.6 amperes. When platinum coating 28 is formed, the negative and positive charges are removed from the base portion 24 and the plating solution, respectively, and base portion 24 (containing platinum coating 28) is removed from the bath.

In one embodiment, cathode ingot 22 undergoes one or more heat treatment processes after platinum coating 28 is formed. For example, cathode ingot 22 may undergo a low-temperature heat treatment process (e.g., about 190°C/about 375°F for about 3 hours) to outgas any byproduct gases from the plating process. One or more high-temperature, heat treatment processes may also be performed to at least partially diffuse the platinum of platinum coating 28 into the MCrAlY alloy of base portion 24. Examples of suitable temperatures for the high-temperature, heat treatment processes include temperatures ranging from about 930°C (about 1700°F) to about 1090°C (about 2000°F), with particularly suitable temperatures ranging from about 1040°C (about 1900°F) to about 1080°C (about 1975°F). Examples of suitable durations include at least about one hour, with particularly suitable durations ranging from about two hours to about four hours. The high-temperature, heat treatment process is also desirably performed under reduced pressure (e.g., partial pressure argon atmosphere) or vacuum conditions. Examples of suitable pressures for performing the high-temperature, heat treatment process include about 13 millipascals (about 10⁻⁴ Torr) or less, with more particularly suitable pressures including about 1.3 millipascals (about 10⁻⁵ Torr) or less. The high-temperature, heat treatment process allows the platinum to infiltrate the MCrAlY alloy in the regions of interest where the cathodic arc will run during the subsequent cathodic arc deposition process.

As shown in FIG. 2C, pursuant to step 16 of method 10, an aluminization process is then performed to interdiffuse aluminum with the platinum of platinum coating 28 (shown in FIG. 2B) and the MCrAIY alloy of base portion 24. This forms PtAl coating 32 and transition region 34, where PtAl coating 32 is an outer coating derived of platinum-modified aluminide, and transition region 34 is a region between base portion 24 and PtAl coating 32 that exhibits a compositional gradient that gradually transitions from the platinum-modified aluminide to the MCrAlY alloy due to the interdiffusion.

The aluminization process may be performed with a variety of techniques, such as vapor-phase aluminization (VPA) processes, pack cementation processes, and chemical vapor deposition processes. For example, in a VPA process, cathode ingot 22 (including base portion 24 and platinum coating 28) is placed in a container that includes aluminum, and the temperature is increased to vaporize the aluminum. Examples of suitable temperatures range from about 815°C (about 1500°F) to about 1060°C (about 2000°F). The vaporized aluminum then deposits on platinum coating 28, thereby forming a two-phase aluminide coating.

Following the VPA process, the coated cathode ingot may undergo one or more additional heat treatment processes to interdiffuse the aluminum, the platinum, and the MCrAlY alloy. Examples of suitable temperatures for the additional heat treatment processes include temperatures ranging from about 930°C (about 1700°F) to about 1090°C (about 2000°F), with particularly suitable temperatures ranging from about 1040°C (about 1900°F) to about 1080°C (about 1975°F). Examples of suitable durations include at least about one hour, with particularly suitable durations ranging from about two hours to about four hours.

The aluminization and heat treatment processes are continued until a desired amount of aluminum is deposited onto platinum coating 28. The resulting concentrations of platinum in PtAl coating 32 may vary depending on coating thickness 30 of platinum coating 28 (shown in FIG. 2B) and on the amount of aluminum added during the aluminization process. Examples of suitable concentrations of platinum in PtAl coating 32 range from about 5% by weight to about 60% by weight, with particularly suitable concentrations of platinum in PtAl coating 32 ranging from about 25% by weight to about 50% by weight, where the concentrations are based on the total weight of the platinum and aluminum.

Similarly, the thickness of the coating-build up above the original location of surface 26 (shown with phantom line in FIG. 2C) may also vary depending on thickness 30 of platinum coating 28, on the amount of aluminum deposited during the aluminization process, and on the inward/outward growth conditions of the aluminization process. The average thickness of the coating-build up, as measured from the original location of surface 26, is represented as coating thickness 36 in FIG. 2C. Examples of suitable coating thicknesses 36 after step 16 of method 10 include thicknesses ranging from about 10 micrometers to about 200 micrometers, with particularly suitable thicknesses ranging from about 50 micrometers to about 100 micrometers, depending on the desired coating thickness on the component.

After the aluminization process is complete, the composition of cathode ingot 22 includes the MCrAlY alloy at base portion 24, the platinum-modified aluminide at PtAl coating 32, and a compositional gradient that gradually transitions from the platinum-modified aluminide of PtAl coating 32 to the MCrAlY alloy of base portion 24 (at transition region 34). The compositional gradient of transition region 34 extends in an inward direction (represented by arrow 38), and desirably exhibits a higher concentration of the platinum-modified aluminide and a lower concentration of the MCrAlY alloy (or is substantially free of the MCrAIY alloy) adjacent PtAl coating 32, and a higher concentration of the MCrAlY alloy and a lower concentration of the platinum-modified aluminide (or is substantially free of the platinum-modified aluminide) adjacent base portion 24.

The average thickness of transition region 34 is represented as region thickness 40 in FIG. 2C, and is measured as the region where the compositional gradient of the MCrAlY alloy and the platinum-modified aluminide exists. The compositional gradient and region thickness 40 may vary depending on the conditions of the aluminization process. For example, in embodiments in which the aluminization process results in a mild interdiffusion between the platinum-modified aluminide and the MCrAIY alloy, region thickness 40 of transition region 34 may be small. Alternatively, in embodiments in which the aluminization process results in a strong interdiffusion between the platinum-modified aluminide and the MCrAlY alloy, region thickness 40 of transition region 34 may be large. For example, in one embodiment, region thickness 40 entirely encompasses PtAl coating 32, thereby allowing the MCrAlY alloy to extend to the surface of cathode ingot 22.

As discussed above, after being formed pursuant to steps 12-16 of method 10, cathode ingot 22 may be mounted in a cathodic arc deposition system (or other suitable physical vapor deposition system) for subsequent use in forming a bond coat on a metal component. The application of the platinum-modified aluminide to cathode ingot 22 allows a multiple-layer bond coat to be formed on the metal component with a single cathodic arc deposition process. This reduces the costs and work levels required to provide oxidation and/or corrosion resistance to metal components of gas turbine engines.

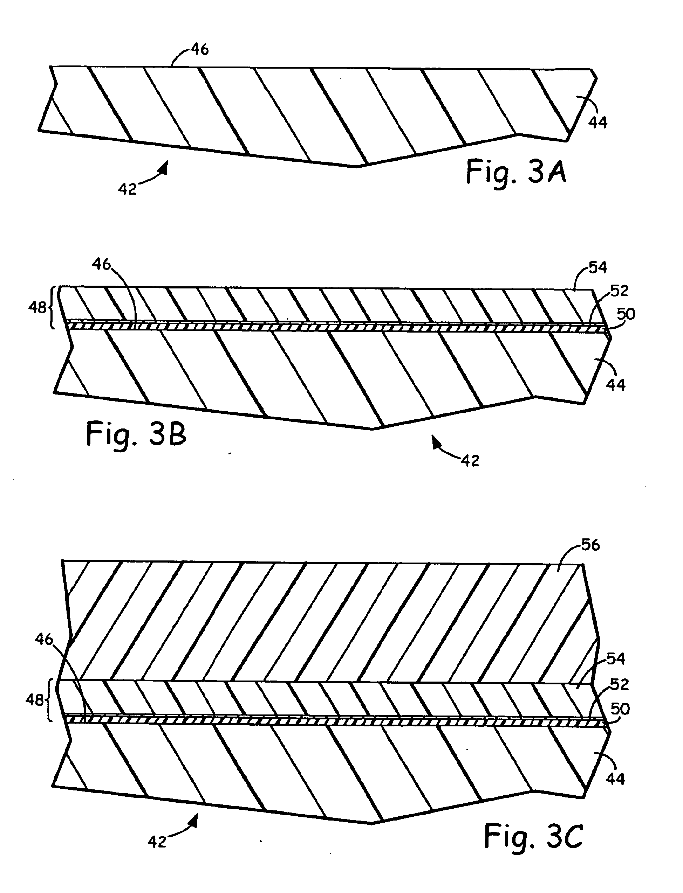

FIGS. 3A-3C are sectional views of metal component 42, which illustrate the method of coating metal component 42 pursuant to steps 18 and 20 of method 10 (shown in FIG. 1). As shown in FIG. 3A, metal component 42 includes substrate 44, which is a substrate of a gas turbine engine component (e.g., turbine blades and vanes). Examples of suitable materials for substrate 44 include nickel-based superalloys, cobalt-based superalloys, and combinations thereof; and may also include one or more additional materials such as titanium, chromium, niobium, hafnium, tantalum, molybdenum, tungsten, aluminum, carbon, and iron. Substrate 44 includes surface 46, which is a surface that will be coated with a bond coat pursuant to step 18 of method 10.

Prior to being mounted in a cathodic arc deposition system (not shown), one or more surfaces of substrate 44 may be masked to prevent the formation of the bond coat on the masked surfaces during the cathodic arc deposition process. For example, the roots of turbine blades and vanes may be masked to prevent the formation of the bond coat on the roots. After substrate 44 is mounted in the chamber, the chamber is then desirably filled with a carrier gas (e.g., argon) under reduced pressure (e.g., about 1.3 Pa (10⁻² Torr)).

FIG. 3B shows metal component 42 with bond coat 48 formed on surface 46. Bond coat 48 includes buffer coating 50, transition coating 52, and overlay coating 54, where buffer coating 50 is an inner PtAl coating disposed on surface 46, overlay coating 54 is an outer MCrAlY alloy coating, and transition coating 52 is an intermediate coating having a compositional gradient that gradually transitions from the platinum-modified aluminide of buffer coating 50 to the MCrAlY alloy of overlay coating 54.

Pursuant to step 18 of method 10, a cathodic arc deposition process is performed on substrate 44 using cathode ingot 22 (shown in FIG. 2C) to form bond coat 48 on surface 46. During the cathodic arc deposition process, an electrical current (e.g., about 300 amperes to about 400 amperes) is relayed from a cathode of the system to cathode ingot 22. This induces an electrical arc that continuously contacts the surfaces of cathode ingot 22, thereby ionizing the metallic atoms at the points of contact. The metallic ions that are formed are blasted away from cathode ingot 22, toward substrate 44. A negative bias (e.g., ranging from about -10 volts to about -100 volts) is desirably applied to substrate 44 to accelerate the attraction of the metallic ions to substrate 44. The metallic ions then deposit on and bond to surface 46 of substrate 44 to form bond coat 48.

As discussed above, the composition of cathode ingot 22 includes the MCrAlY alloy at base portion 24, the platinum-modified aluminide at PtAl coating 32, and a compositional gradient at transition region 34. As such, the continuous contacts of the electrical arc with the surface of cathode ingot 22 initially cause metallic ions of the platinum-modified aluminide (from PtAl coating 32) to form and deposit onto surface 46 of substrate 44 to form buffer coating 50.

As the process continues, successive surface portions of cathode ingot 22 are blasted away, which exposes the underlying compositional gradient of transition region 34. The continuous contacts of the cathodic arc with the exposed surfaces of transition region 34 form metallic ions of the MCrAlY alloy and the platinum-modified aluminide in accordance with the compositional gradient. These metallic ions then deposit onto buffer coating 50 to form transition coating 52.

As the process further continues, the composition of bond coat 48 formed on surface 46 continues to follow the compositional profile of cathode ingot 22. Thus, after a given duration, the MCrAlY alloy of base portion 24 is exposed to the cathodic arc. The continuous contacts of the cathodic arc with the surfaces of base portion 24 form metallic ions of the MCrAlY alloy, which deposit onto transition coating 52 to form overlay coating 54. The process may continue until a desired thickness of overlay coating 54 is achieved, or until the supply of the MCrAlY alloy in cathode ingot 22 becomes depleted.

After the cathodic arc deposition process is complete, the resulting bond coat 48 includes an initial layer of the platinum-modified aluminide (i.e., buffer coating 50) disposed on surface 46, a compositional gradient that gradually transitions from the platinum-modified aluminide to the MCrAlY alloy (i.e., transition coating 52), and an exterior layer of the MCrAlY alloy (i.e., overlay coating 54). As discussed above, this combination provides good oxidation and/or corrosion protection to substrate 44 regardless of the microstructure of substrate 44 (e.g., single-crystal and polycrystalline/equiaxed/directionally-solidified microstructures). Additionally, the compositional gradient of transition coating 52 provides a strong intercoating bond between buffer coating 50 and overlay coating 54.

Furthermore, the use of the cathodic arc deposition process allows bond coat 48 to be thin, thereby substantially preserving the fatigue properties of metal component 42 during the course of operation in a gas turbine engine. Examples of suitable average thicknesses for bond coat 48 on surface 46 of substrate 44 range from about 25 micrometers to about 200 micrometers, with particularly suitable thicknesses ranging from about 50 micrometers to about 100 micrometers.

While the above discussion of the cathodic arc deposition process is made with reference to a single metal component (i.e., metal component 42), step 18 of method 10 is also suitable for forming bond coats (e.g., bond coat 48) on multiple metal components with a single cathodic arc deposition process. In this embodiment, each of the multiple metal components may be mounted in a single cathodic arc deposition system that includes cathode ingot 22. An example of a suitable system for mounting multiple metal components is disclosed in Beers et al., U.S. Patent No. 6,224,726. Cathode ingot 22 is desirably mounted in a central location relative to the mounted metal components, thereby providing a direct access between cathode ingot 22 and each of the metal components. The metal components may also be mounted to rotatable, revolving mounts, which allow opposing surfaces of the metal components to face cathode ingot 22 during the cathodic arc deposition process.

FIG. 3C shows metal component 42 with thermal barrier coating 56. After bond coat 48 is formed on substrate 44, metal component 42 may be removed from the chamber of the cathodic arc deposition system, and thermal barrier coating 56 may be formed on bond coat 48, pursuant to step 20 of method 10. Thermal barrier coating 56 is a ceramic coating that thermally insulates substrate 44 during the course of operation in a gas turbine engine. Suitable materials for thermal barrier coating 56 include zirconia-based materials, where the zirconia is desirably modified with a stabilizer to prevent the formation of a monoclinic phase, and pyrochlores. Examples of suitable stabilizers include yttria, gadolinia, calcia, ceria, magnesia, and combinations thereof.

Thermal barrier coating 56 may be formed on bond coat 48 using a variety of deposition techniques, such as electron beam-physical vapor deposition (EB-PVD), plasma spray, chemical vapor deposition, and cathodic arc deposition. Examples of suitable coating thicknesses for thermal barrier coating 56 range from about 25 micrometers to about 1,000 micrometers, with particularly suitable coating thicknesses ranging from about 100 micrometers to about 500 micrometers. After thermal barrier coating 56 is formed, metal component 42 may undergo one or more post-coating processes, and may then be installed in a gas turbine engine.

Although the present invention has been described with reference to preferred embodiments, workers skilled in the art will recognize that changes may be made in form and detail without departing from the scope of the invention, which is defined by the claims and their equivalents.

## Claims

1. A method for coating a metal component of a gas turbine engine, the method comprising:
forming a cathode ingot for a cathodic arc deposition process, the cathode ingot comprising a base portion and an outer coating disposed over the base portion, wherein the base portion comprises an MCrAlY alloy and the outer coating comprises platinum-modified aluminide; and
performing a cathodic arc deposition process on the metal component with the cathode ingot to form a bond coat comprising:
a buffer coating disposed on a surface of the metal component, and comprising at least a portion of the platinum-modified aluminide of the outer coating of the cathode ingot; and
an overlay coating disposed over the buffer coating, and comprising at least a portion of the MCrAlY alloy of the base portion of the cathode ingot.

2. The method of claim 1 wherein the cathodic arc deposition process comprises inducing a cathodic arc to contact the outer coating of the cathode ingot, thereby
forming metallic ions of the platinum-modified aluminide; depositing the metallic ions of the platinum-modified aluminide onto the metal
component to form a buffer coating on the metal component; inducing the cathodic arc to contact the base portion of the cathode ingot, thereby
forming metallic ions of the MCrAlY alloy; and depositing the metallic ions of the MCrAlY alloy over the buffer coating to form
an overlay coating.

3. The method of claim 1 or 2, wherein the cathode ingot further comprises a transition region between the base portion and the outer coating, the transition region comprising a compositional gradient that transitions from the platinum-modified aluminide of the outer coating to the MCrAlY alloy of the base portion.

4. The method of claim 3, wherein the bond coat further comprises a transition coating disposed between the buffer coating and the overlay coating, the transition coating comprising a compositional gradient that transitions from the platinum-modified aluminide of the buffer coating to the MCrAlY alloy of the overlay coating.

5. The method of claim 4, wherein the cathodic arc deposition process comprises
inducing a cathodic arc to contact the transition region of the cathode ingot, thereby forming metallic ions of the MCrAlY alloy of the transition region and metallic ions of the platinum-modified aluminide of the transition region; and
depositing the metallic ions of the MCrAlY alloy of the transition region and metallic ions of the platinum-modified aluminide of the transition region over the buffer coating to form a transition coating.

6. The method of any preceding claim, wherein forming the cathode ingot comprises:
forming the base portion of the cathode ingot;
forming a platinum coating on the base portion to form a platinum-coated base portion; and
performing an aluminization process on the platinum-coated base portion.

7. The method of claim 6, wherein forming the platinum coating on the base portion of the cathode ingot comprises electroplating the base portion.

8. The method of claim 6 or 7, further comprising performing at least one heat treatment process on the cathode ingot after performing the aluminization process.

9. The method of any preceding claim, further comprising forming a thermal barrier coating over the overlay coating.

10. The method of any preceding claim, wherein the bond coat has an average thickness ranging from about 25 micrometers to about 200 micrometers, preferably from about 50 micrometers to about 100 micrometers.

11. A metal component (42) of a gas turbine engine, the metal component comprising:
a substrate (44) having a surface (46); and
a bond coat (48) formed on the substrate with a cathodic arc deposition process using a cathode ingot, the bond coat comprising:
a buffer coating (50) disposed on the surface of the substrate, and comprising a platinum-modified aluminide deposited on the surface from an outer layer of the cathode ingot; and
an overlay coating (54) disposed over the buffer coating, and comprising an MCrAlY alloy deposited from a base portion of the cathode ingot.

12. The metal component of claim 11, wherein the substrate comprises an alloy selected from the group consisting of nickel-based superalloys, cobalt-based superalloys, and combinations thereof.

13. The metal component of claim 11 or 12, wherein the bond coat further comprises a transition coating (52) disposed between the buffer coating and the overlay coating, the transition coating comprising a compositional gradient that transitions from the platinum-modified aluminide of the buffer coating to the MCrAlY alloy of the overlay coating.

14. The metal component of claim 11, 12 or 13, further comprising a thermal barrier coating (56) disposed over the overlay coating (54).

15. The metal component of claim 11, 12, 13 or 14, wherein the bond coat (48) has an average thickness ranging from about 25 micrometers to about 200 micrometers, preferably from about 50 micrometers to about 100 micrometers.

## Patentansprüche

1. Verfahren zum Beschichten eines Metallbauteils eines Gasturbinenmotors, wobei das Verfahren umfasst:
Bilden eines Kathodenblocks für ein Lichtbogenverdampfungsverfahren, wobei der Kathodenblock einen Basisabschnitt und eine über dem Basisabschnitt angeordnete äußere Beschichtung umfasst, wobei der Basisabschnitt eine MCrAlY-Legierung umfasst und die äußere Beschichtung mit Platin modifiziertes Aluminid umfasst; und
Durchführen eines Lichtbogenverdampfungsverfahrens auf dem Metallbauteil mit dem Kathodenblock, um eine Haftschicht auszubilden, die umfasst:
eine Pufferbeschichtung, die auf einer Oberfläche des Metallbauteils angeordnet ist und zumindest einen Teil des mit Platin modifizierten Aluminids der äußeren Beschichtung des Kathodenblocks umfasst; und
eine Deckbeschichtung, die über der Pufferbeschichtung angeordnet ist und zumindest einen Teil der MCrAlY-Legierung des Basisabschnitts des Kathodenblocks umfasst.

2. Verfahren nach Anspruch 1, wobei das Lichtbogenverdampfungsverfahren umfasst:
Bewirken, dass ein Kathodenbogen die äußere Beschichtung des Kathodenblocks kontaktiert, wodurch Metallionen des mit Platin modifizierten Aluminids gebildet werden;
Abscheiden der Metallionen des mit Platin modifizierten Aluminids auf dem Metallbauteil, um auf dem Metallbauteil eine Pufferbeschichtung zu bilden;
Bewirken, dass der Kathodenbogen den Basisabschnitt des Kathodenblocks kontaktiert, wodurch Metallionen der MCrAlY-Legierung gebildet werden; und
Abscheiden der Metallionen der MCrAlY-Legierung über der Pufferbeschichtung, um eine Deckbeschichtung zu bilden.

3. Verfahren nach Anspruch 1 oder 2, wobei der Kathodenblock ferner einen Übergangsbereich zwischen dem Basisabschnitt und der äußeren Beschichtung umfasst, wobei der Übergangsbereich einen Zusammensetzungsgradienten umfasst, der von dem mit Platin modifizierten Aluminid der äußeren Beschichtung zu der MCrAlY-Legierung des Basisabschnitts übergeht.

4. Verfahren nach Anspruch 3, wobei die Haftschicht ferner eine zwischen der Pufferbeschichtung und der Deckbeschichtung angeordnete Übergangsbeschichtung umfasst, wobei die Übergangsbeschichtung einen Zusammensetzungsgradienten umfasst, der von dem mit Platin modifizierten Aluminid der Pufferbeschichtung zu der MCrAlY-Legierung der Deckbeschichtung übergeht.

5. Verfahren nach Anspruch 4, wobei das Lichtbogenverdampfungsverfahren umfasst:
Bewirken, dass ein Kathodenbogen den Übergangsbereich des Kathodenblocks kontaktiert, wodurch Metallionen der MCrAlY-Legierung des Übergangsbereichs und Metallionen des mit Platin modifizierten Aluminids des Übergangsbereichs gebildet werden; und
Abscheiden der Metallionen der MCrAlY-Legierung des Übergangsbereichs und der Metallionen des mit Platin modifizierten Aluminids des Übergangsbereichs über der Pufferbeschichtung, um eine Übergangsbeschichtung zu bilden.

6. Verfahren nach einem vorangehenden Anspruch, wobei das Bilden des Kathodenblocks umfasst:
Bilden des Basisabschnitts des Kathodenblocks;
Bilden einer Platinbeschichtung auf dem Basisabschnitt, um einen mit Platin beschichteten Basisabschnitt zu bilden; und
Durchführen eines Aluminierverfahrens an dem mit Platin beschichteten Basisabschnitt.

7. Verfahren nach Anspruch 6, wobei das Bilden der Platinbeschichtung an dem Basisabschnitt des Kathodenblocks das Galvanisieren des Basisabschnitts umfasst.

8. Verfahren nach Anspruch 6 oder 7, das ferner die Durchführung mindestens eines Wärmebehandlungsverfahrens an dem Kathodenblock nach der Durchführung des Aluminierverfahrens umfasst.

9. Verfahren nach einem der vorangehenden Ansprüche, das ferner das Bilden einer Hitzebarrierebeschichtung über der Deckbeschichtung umfasst.

10. Verfahren nach einem vorangehenden Anspruch, wobei die Haftschicht eine durchschnittliche Dicke im Bereich von ca. 25 Mikrometern bis ca. 200 Mikrometern, vorzugsweise von ca. 50 Mikrometern bis ca. 100 Mikrometern, aufweist.

11. Metallbauteil (42) eines Gasturbinenmotors, wobei das Metallbauteil umfasst:
ein Substrat (44) mit einer Oberfläche (46); und
eine Haftschicht (48), die mit einem Lichtbogenverdampfungsverfahren unter Verwendung eines Kathodenblocks auf dem Substrat gebildet wird, wobei die Haftschicht umfasst:
eine Pufferbeschichtung (50), die auf der Oberfläche des Substrats angeordnet ist und ein mit Platin modifiziertes Aluminid umfasst, das von einer äußeren Schicht des Kathodenblocks her auf der Oberfläche abgeschieden wird; und
eine Deckbeschichtung (54), die über der Pufferbeschichtung angeordnet ist und eine MCrAlY-Legierung umfasst, die von einem Basisabschnitt des Kathodenblocks her abgeschieden wird.

12. Metallbauteil nach Anspruch 11, wobei das Substrat eine Legierung umfasst, die ausgewählt ist aus der Gruppe bestehend aus Superlegierungen auf Nickelbasis, Superlegierungen auf Cobaltbasis und Kombinationen derselben.

13. Metallbauteil nach Anspruch 11 oder 12, wobei die Haftschicht ferner eine Übergangsbeschichtung (52) umfasst, die zwischen der Pufferbeschichtung und der Deckbeschichtung angeordnet ist, wobei die Übergangsbeschichtung einen Zusammensetzungsgradienten umfasst, der von dem mit Platin modifizierten Aluminid der Pufferbeschichtung zu der MCrAlY-Legierung der Deckbeschichtung übergeht.

14. Metallbauteil nach Anspruch 11, 12 oder 13, das ferner eine Hitzebarrierebeschichtung (56) umfasst, die über der Deckbeschichtung (54) angeordnet ist.

15. Metallbauteil nach Anspruch 11, 12, 13 oder 14, wobei die Haftschicht (48) eine durchschnittliche Dicke im Bereich von ca. 25 Mikrometern bis ca. 200 Mikrometern, vorzugsweise von ca. 50 Mikrometern bis ca. 100 Mikrometern, aufweist.

## Revendications

1. Procédé de revêtement d'un composant métallique d'un moteur de turbine à gaz, le procédé comprenant les étapes consistant à :
former un lingot cathodique pour un processus de dépôt par arc cathodique, le lingot cathodique comprenant une portion de base et un revêtement externe disposé par-dessus la portion de base, dans lequel la portion de base comprend un alliage MCrAlY et le revêtement externe comprend un aluminure modifié au platine ; et
effectuer un processus de dépôt par arc cathodique sur le composant métallique avec le lingot cathodique pour former une couche de liaison, comprenant :
un revêtement tampon disposé sur une surface du composant métallique et comprenant au moins une portion de l'aluminure modifié au platine du revêtement externe du lingot cathodique ; et
un revêtement de recouvrement disposé par-dessus le revêtement tampon et comprenant au moins une portion de l'alliage MCrAlY de la portion de base du lingot cathodique.

2. Procédé selon la revendication 1, dans lequel le processus de dépôt par arc cathodique comprend les étapes consistant à :
induire un arc cathodique à venir en contact avec le revêtement externe du lingot cathodique, formant de la sorte des ions métalliques de l'aluminure modifié au platine ;
déposer les ions métalliques de l'aluminure modifié au platine sur le composant métallique pour former un revêtement tampon sur le composant métallique ;
induire l'arc cathodique à venir en contact avec la portion de base du lingot cathodique, formant de la sorte des ions métalliques de l'alliage MCrAlY ; et
déposer les ions métalliques de l'alliage MCrAlY par-dessus le revêtement tampon pour former un revêtement de recouvrement.

3. Procédé selon la revendication 1 ou la revendication 2, dans lequel le lingot cathodique comprend en outre une région de transition entre la portion de base et le revêtement externe, la région de transition comprenant un gradient de composition qui fait la transition entre l'aluminure modifié au platine du revêtement externe et l'alliage MCrAlY de la portion de base.

4. Procédé selon la revendication 3, dans lequel la couche de liaison comprend en outre un revêtement de transition disposé entre le revêtement tampon et le revêtement de recouvrement, le revêtement de transition comprenant un gradient de composition qui fait la transition entre l'aluminure modifié au platine du revêtement tampon et l'alliage MCrAlY du revêtement de recouvrement.

5. Procédé selon la revendication 4, dans lequel le processus de dépôt par arc cathodique comprend les étapes consistant à :
induire un arc cathodique à venir en contact avec la région de transition du lingot cathodique, formant de la sorte des ions métalliques de l'alliage MCrAlY de la région de transition et des ions métalliques de l'aluminure modifié au platine de la région de transition ; et
déposer les ions métalliques de l'alliage MCrAlY de la région de transition et les ions métalliques de l'aluminure modifié au platine de la région de transition par-dessus le revêtement tampon pour former un revêtement de transition.

6. Procédé selon l'une quelconque des revendications précédentes, dans lequel la formation du lingot cathodique comprend les étapes consistant à :
former la portion de base du lingot cathodique ;
former un revêtement de platine sur la portion de base pour former une portion de base revêtue de platine ; et
effectuer un processus d'aluminisation sur la portion de base revêtue de platine.

7. Procédé selon la revendication 6, dans lequel la formation du revêtement de platine sur la portion de base du lingot cathodique comprend une électrodéposition sur la portion de base.

8. Procédé selon la revendication 6 ou la revendication 7, comprenant en outre la réalisation d'au moins un processus de traitement thermique sur le lingot cathodique après l'exécution du processus d'aluminisation.

9. Procédé selon l'une quelconque des revendications précédentes, comprenant en outre la formation d'un revêtement barrière thermique par-dessus le revêtement de recouvrement.

10. Procédé selon l'une quelconque des revendications précédentes, dans lequel la couche de liaison a une épaisseur moyenne d'environ 25 micromètres à environ 200 micromètres, de préférence d'environ 50 micromètres à environ 100 micromètres.

11. Composant métallique (42) d'un moteur de turbine à gaz, le composant métallique comprenant :
un substrat (44) ayant une surface (46) ; et
une couche de liaison (48) formée sur le substrat avec un processus de dépôt par arc cathodique en utilisant un lingot cathodique, la couche de liaison comprenant :
un revêtement tampon (50) disposé sur la surface du substrat et comprenant un aluminure modifié au platine déposé sur la surface à partir d'une couche externe du lingot cathodique ; et
un revêtement de recouvrement (54) disposé par-dessus le revêtement tampon et comprenant un alliage MCrAlY déposé à partir d'une portion de base du lingot cathodique.

12. Composant métallique selon la revendication 11, dans lequel le substrat comprend un alliage choisi dans le groupe constitué des superalliages à base de nickel, des superalliages à base de cobalt et de leurs combinaisons.

13. Composant métallique selon la revendication 11 ou la revendication 12, dans lequel la couche de liaison comprend en outre un revêtement de transition (52) disposé entre le revêtement tampon et le revêtement de recouvrement, le revêtement de transition comprenant un gradient de composition qui fait la transition entre l'aluminure modifié au platine du revêtement tampon et l'alliage MCrAlY du revêtement de recouvrement.

14. Composant métallique selon la revendication 11, 12 ou 13, comprenant en outre un revêtement barrière thermique (56) disposé par-dessus le revêtement de recouvrement (54).

15. Composant métallique selon la revendication 11, 12, 13 ou 14, dans lequel la couche de liaison (48) a une épaisseur moyenne d'environ 25 micromètres à environ 200 micromètres, de préférence d'environ 50 micromètres à environ 100 micromètres.
